# EUROPÄISCHE PATENTSCHRIFT

(11) **EP 1 932 939 B1**
(45) Veröffentlichungstag und Bekanntmachung des Hinweises auf die Patenterteilung: **26.10.2011**
(21) Anmeldenummer: 07022072.8
(22) Anmeldetag: 14.11.2007
(51) Int. Cl.: C23C 14/34, C23C 14/06, H01L 31/032

(54) **Beschichtungswerkstoff auf Basis einer Kupfer-Indium-Gallium-Legierung, insbesondere zur Herstellung von Sputtertargets, Rohrkathoden und dergleichen**
Copper/indium/gallium alloy-based coating material, particularly for the manufacturing of sputter targets, tube cathodes and similar
Matériau de revêtement à base d'un alliage de cuivre/indium/gallium, en particulier pour la fabrication de cibles de circuits, de cathodes tubulaires et analogues

(30) Priorität: 23.11.2006 DE 102006055662
(43) Veröffentlichungstag der Anmeldung: 18.06.2008
(73) Patentinhaber: GfE Metalle und Materialien GmbH, 90431 Nürnberg (DE)
(72) Erfinder: van Osten, Karl-Uwe, 90584 Allersberg (DE); Britting, Stefan, 91220 Schnaittach (DE)
(74) Vertreter: Hübner, Gerd

(56) Entgegenhaltungen:
- EP-A- 0 881 695
- US-A1- 2004 063 320
- HO KEUN SONG ET AL.: "Preparation of CuIn1-xGaxSe2 thin films by sputtering and selenization process" SOLAR ENERGY MATERIALS & SOLAR CELLS, Nr. 75, 2003, Seiten 145-153, XP002468138
- EDITOR-IN-CHIEF THADDEUS MASSALSKI: "Binary Alloy Phase Diagrams Volume 2" 1990, ASM , XP002468139 * Seite 1410 - Seite 1412 *

## Beschreibung

Die Erfindung betrifft einen Beschichtungswerkstoff auf Basis einer Kupfer-Indium-Gallium(CuInGa)-Legierung insbesondere zur Herstellung von Sputtertargets, Rohrkathoden und dergleichen Beschichtungswerkstoffquellen.

Die schmelzmetallurgische Herstellung einer CuInGa-Legierung ist grundsätzlich aus der DE 698 35 851 T2 bekannt. Die dort erwähnte Legierung entspricht in ihren Anteilsverhältnissen im Wesentlichen denen der im Folgenden offenbarten Erfindung. Die EP 0 308 201 A1 bezieht sich auf ein Sputtertarget zur Verwendung im Produktionsprozess von magnetooptischen Aufzeichnungsmedien. Entsprechend offenbart US 6 682 636 B2 PVD-Targets und Verfahren zu ihrer Bildung. Beide Druckschriften lehren jedoch nicht die Verwendung einer CuInGa-Legierung als Beschichtungswerkstoff. Nächstliegender Stand der Technik ist die EP 0 881 695 A2, die ein Pulver, bestehend aus 50,78 Gew.-% Indium, 36 Gew.-% Kupfer und 13,22 Gew.-% Ga. Dieses Pulver wird nach der Beimischung von Selen zur Herstellung einer Schicht verwendet.

Einsatzgebiet ist die Herstellung von Dünnschichtsolarzellen mit einer Halbleiterschicht aus CuInGaSe2 oder CuInGaS2 (Sammelabkürzung: CIGS). Hierbei wird eine elektrisch leitfähige CuInGa - Schicht in gewünschter Zusammensetzung auf ein mit Molybdän beschichtetes Substrat (KNS-Glas) abgeschieden, z.B. aufgedampft oder gesputtert. In einem weiterführenden Schritt wird die Schicht in Se- oder S-haltiger Atmosphäre selenisiert oder sulfitisiert, um ihre halbleitenden Eigenschaften zu erhalten. Die CIGS - Schicht ist ein Teil der aus einem Schichtpaket aufgebauten Schichtsystem einer Dünnschichtsolarzelle.

Das Aufbringen der CuInGa Schicht erfolgt bisher über Koverdampfen elementarer Verdampfungsquellen (Cu, In, Ga separat) oder über schichtweise abwechselndes Aufdampfen binärer Vorlegierungen aus dem System Cu - In - Ga. Diese Prozesse können nur schwer über einen längeren Zeitraum konstante Ergebnisse in der Schichtzusammensetzung liefern. Ein Problem ist z.B. ein Cu - Defizit beim Einsatz dieser Methoden oder eine Ungleichverteilung der eingesetzten Elemente.

Zudem sind oft mehrere Schritte zum Aufbringen der CIG - Schicht notwendig, da nicht alle drei Elemente durch Sputtern abgeschieden werden können. Ga nämlich besitzt einen Schmelzpunkt von 30°C, was während dem Beschichtungsprozess unweigerlich zum Aufschmelzen und somit Abtropfen des Ga-Metalls führt.

Die elektrische Leitfähigkeit aufgrund der Halbleitereigenschaften dieses Metalls ist sehr schlecht. Dieses wiederum führt zur Erhitzung des Gallium-Metalls bis zur schmelzflüssigen Phase. Der Beschichtungsprozess kommt somit zum Erliegen.

Nach jetzigem Kenntnisstand werden bereits Sputtertargets, planar oder als Rohrkathoden, mit den drei Komponenten Cu, In und Ga zum Erzeugen der halbleitenden CIGS - Schichten entwickelt, zeigen jedoch vielfältige ungünstige Materialerscheinungen sowie durch ungeeignete Schmelzführung bei der Herstellung des ternären Beschichtungswerkstoffs sehr schlechte Sputter- und Schichteigenschaften.

Bisherige Verfahren zur Herstellung der CIGS - Schicht auf verschiedenen Substraten sind folgende:
- Bei simultanem Aufdampfen der einzelnen Elemente mit verschiedenen Aufdampfraten mit und ohne Selen mit nachfolgendem Temperschritt reagiert die Schicht zur halbleitenden Chalkophyrit-Struktur.
- Aufdampfen (Ga)/Aufsputtern (In/Cu) als einzelne Schichten mit nachfolgendem Temperschritt (mit Selenisierung) - dies auch unter Verwendung binärer Metalltargets (CuGa + In oder CuIn + Ga) verschiedener Zusammensetzungen.
- Aufsputtern der Oxidverbindungen der drei Metalle mit nachfolgender Reduzierung in z.B. H2 zur reinen Metallschicht.
- Schichtabscheidung ausgehend von den Se - haltigen Verbindungen In2Se3, Ga2Se3, In/Ga2Se3 und Cu2Se.
- Magnetronsputtern der direkten Verbindungshalbleitermaterialien Cu-InSe2 oder CuInS2. Die damit hergestellten Solarzellen weisen einen zu geringen Wirkungsgrad auf.
- Weitere Verfahren, die sich mit dem galvanischen Aufbringen oder Aufdrucken der einzelnen Schichten beschäftigen, befinden sich in der Testphase.

In keinem der oben genannten "herkömmlichen" Herstellungsverfahren wurde ein Sputtertarget erfolgreich verwendet, das die drei Elemente Cu, In und Ga im gewünschten Verhältnis in sich vereinigt.

Die gängigste Methode zur Herstellung der CIGS - Schicht im industriellen Maßstab ist das Ko - Sputtern von Targets bestehend aus CuGa (65 - 80 Gew.% Cu) und In. Die Selenisierung erfolgt in einem nachfolgenden Temperschritt bei 500°C in Se-haltiger Atmosphäre (Dauer ca. 3min).

Die Vorteile der entwickelten CuInGa - Targets in den gewünschten Zusammensetzungen liegen in der Verwendung eines einzigen Sputtertarget für den Beschichtungsprozess. Dies bietet höhere Prozessstabilität und genau einstellbare Stöchiometrien sowie Kostenreduzierung und Recyclingfähigkeit der Rest-Beschichtungsmaterialien sowie eine notwendig hohe Schmelztemperatur der Legierung besonders bezüglich des Elements Gallium.

Aufgabe der vorliegenden Erfindung ist es, einen Beschichtungswerkstoff bereitzustellen, mit dem ein Aufdampfen von CIG-Schichten in einem einzigen Schritt möglich ist. Mit einer Verdampfungsquelle, die die richtige Zusammensetzung, eine gute elektrische Leitfähigkeit besitzt und deren Schmelzpunkt über 200°C liegt, wird der Prozess nämlich auf einen PVD-Beschichtungsschritt verkürzt. Die gewünschte Zusammensetzung der Schicht ist dann kein Problem mehr, die Selenierung kann wie gehabt nachfolgend durch Verdampfung erfolgen.

Diese Aufgabe wird durch die im Patentanspruch 1 angegebenen Legierungsmerkmale gelöst.

Demnach weist die als Beschichtungswerkstoff zum Einsatz kommende Kupfer-Indium-Gallium-Legierung eine Phase nach Art einer Prototyp-Cu5Zn8-Phase auf, in der die Gitterplätze der Zinkatome (Zn) durch Galliumatome besetzt sind (Gallium-substituierte Cu5Zn8-Phase) und bei der zugleich Indium mit einem Anteil von bis zu 26 Gew.% in die Elementarzelle oder Phase eingelagert ist zugleich Indium mit einem Anteil von bis zu 22 Gew.% in die Elementarzelle oder Phase eingelagert ist

Vorzugsweise ist die Verwendbarkeit dieser ternären Legierung für den Beschichtungsprozess gewährleistet.

Das Herstellungsverfahren für den erfindungsgemäßen Beschichtungswerkstoff weist folgenden Verfahrensschritt auf:
Die Legierung wird schmelzmetallurgisch aus den Bestandteilen Cu, In und Ga hergestellt.

Eine bevorzugte Ausführungsform der Erfindung ist im abhängigen Ansprüch 2 angegeben.

Grundsätzlich ist es auch möglich, dass sich ausgehend von pulvermetallurgischen Herstellungsprozessen der ternären Zusammensetzung erst während des Beschichtungsverfahrens "in statu nascendi" eine Gallium-substituierte Cu5Zn8-Phase mit Einlagerung von Indium bildet. So können pulvermetallurgische Verfahren verwendet werden, um CuInGa-Materialien herzustellen, die entweder aus Elementpulvern oder Legierungspulvern der binären Legierungen hergestellt werden. Die Pulver werden entsprechend der gewünschten Endzusammensetzung gemischt und durch Pressen entsprechender Formteile hergestellt. Die Ausbildung der notwendigen Phase kann bei diesen Materialien auf der Targetoberfläche oder sogar erst auf dem Substrat selber als dünne Schicht erfolgen.

Hinsichtlich der Kupfer-Indium-Gallium-Legierung hat sich überraschenderweise gezeigt, dass bei definierter Legierungszusammensetzung des sogar bis zu > 400 °C erhöht werden kann, ohne dass eine selektives Aufschmelzen der Elemente Ga und In erfolgt, obwohl die Schmelztemperaturen dieser Elemente mit Ga = 30 °C und In = 156 °C weit darunter liegen.

Eingehende Phasenuntersuchungen haben gezeigt, dass durch die angestrebte Bildung von intermetallischen Verbindungen mit gleichzeitiger Einlagerung eines weiteren dritten Elements in den Tetraeder- oder Oktaederlücken dieser Phase der gewünschte Effekt der Schmelztemperaturerhöhung erzielt werden kann. Begründet wird dies durch die in dieser Phase sich einstellenden Bindungsenergien, die die Summe aus metallischen und kovalenten Bindungsanteilen ermöglichen. Notwendiges "Muss" bleibt hierbei die Möglichkeit der Einlagerung eines dritten Elements in Volumenanteilen von mindestens bis zu 22 Gew.%.

Die Phasenbildung mit einhergehender Einlagerung war bis dato im ternären System Cu - In - Ga unbekannt und ist in diesem Fall von der sich durch die genauen Legierungszusammensetzung, den Herstellungsparametem und der verwendeten Schmelztechnik abhängig.

Weitere Untersuchungen haben gezeigt, dass diese neu entdeckte Phase aufgrund der geometrischen Anforderung der Atome Cu und Gallium ähnlich der bekannten Prototyp-Phase Cu5Zn8 ist, wobei in diesem speziellen Fall die Zn-Atome durch Ga ersetzt werden. Bemerkenswert ist hierbei der Einbau von In-Atomen mit einem Anteil von bis zu > 22 Gew.% Indium in die Phase. Erst durch die Bildung dieser Phase wird somit die Verwendbarkeit des Beschichtungswerkstoffs sichergestellt. Hierbei ist ebenfalls wichtig, dass diese bisher nicht in der Literatur bekannte Phase die Verdampfungs- und Sputtereigenschaften dieser ternären Legierung in keinem Fall negativ beeinflussen. Der Nachweis hierfür wurde in mehreren Beschichtungsversuchen sichergestellt.

Die π -Phase definiert sich somit im ternären Cu - In - Ga-Legierungssystem als Phase des Prototyp-Gittertyps - Cu5Zn8 mit gleichzeitiger Einlagerung von bis zu >22 Gew.% an Indium, wobei das Indium röntgendiffraktometrisch ungeordnet in den vorhandenen Tetraeder- und Oktraederlücken der Elementarzelle der Phase eingelagert ist.

In Anlehnung an den Phasen-Prototyp Cu5Zn8 ergeben sich folgende Literaturwerte:

| Temperatur (k) | |
|---|---|
| Dichte | 8,054 g/cm³ |
| Molares Volumen | 1.04402 cm³/mol |
| Expansionskoeffizient | 26,90 (10⁻⁶/k) |
| Spez. Wärme | 387 (J/kg k) |
| Atom-Positionen | X = 0,313 |
| | Y = 0,313 |
| | Z = 0,036 |
| Volumengruppe | 143m |

Somit lässt sich die π -Phase als kubisches Phasensystem definieren.

Im Folgenden wird die Erfindung anhand der beigefügten Zeichnungen näher beschrieben. Es zeigen:
- Fig. 1: ein Anschliffbild einer Legierung CuInGa 35,8 - 52,4 - 11,8wt%, schnell abgekühlt,
- Fig. 2: ein Anschliffbild einer Legierung CuInGa 62 - 17 - 21 wt%, π - Phase - mit verfahrentechnisch bedingten Gussporen,
- Fig. 3: ein Röntgenspektrum der π - Phase,
- Fig. 4: ein EDX - Spektrum zur Bestimmung der chem. Zusammensetzung der in Fig. 1 zu sehenden dunklen Bereiche (π - Phase),
- Fig. 5: ein EDX - Spektrum der hellen Matrix aus Fig.1,
- Fig. 6: ein Anschliffbild mit π - Phase bei langsamerer Abkühlung,
- Fig. 7: ein EDX-Spektrum der π - Phase der langsam abgekühlten Schmelze,
- Fig. 8: ein EDX-Spektrum der Matrix der langsam abgekühlten Schmelze, und
- Fig. 9: EDX - Spektren von sechs untersuchten Punkten auf der Schlifffläche von Fig. 2.

Innerhalb erschmolzener CuInGa - Legierungen stellt sich bei definierter Legierungszusammensetzung und Schmelzenführung sowie Erstarrungsgeschwindigkeit eine kubische Phase des Prototypen-Phasen-Gittertyps Cu5Zn8 ein, wobei in diesem Fall Gallium den Platz des Zink einnimmt.

Indium ist bis zu 22 Gewichtsprozent (wt%) in dieser Phase gelöst. Indium-Gehalte größer 25wt% scheiden sich als die o.g. Phase umgebende Matrix aus. Bei Kupfer-Gehalten über 63wt% werden Indium und Gallium entweder im Cu gelöst oder bilden mit Kupfer folgende binäre Verbindungen:

| | Phase | Stabilitätsbereich in K |
|---|---|---|
| Cu₂Ga | γ₁ | 298-918 |
| Cu₂Ga | γ | 763-1109 |
| Cu₃Ga | β | 298-1188 |
| Cu₅Ga₃ | γ₂ | 298-758 |
| Cu₇Ga₂ | ζ' | 298-595 |
| Cu₇Ga₂ | ζ | 603-893 |
| Cu₇In₄ | δ | 298-904 |
| Cu₄In | β | 847-983 |

Das binäre Legierungssystem InGa bildet keine Phasen, dafür ein niedrigschmelzendes Eutektikum bei 15 °C aus.

Dies ist entnehmbar folgender Literatur:
- "Constitution Of Binary Alloys", Hansen, 2. Auflage 1958 ; Metallurgy and Metallurgical Engineering Series.
- TAPP Plus Version 2.2; E S Microwave Inc.

Bedingt durch die Bildung der Phase hier des Phasen-Prototyps Cu5Zn8 mit Substitution von Zink durch Gallium mit gleichzeitiger Einlagerung von Indium (im folgenden π - Phase genannt) wird die geringe Schmelztemperatur der Elemente Gallium von 302,91K auf Temperaturen weit größer 502,91K und Indium von 429,15K auf größer 529,15K erhöht. Dies bedingt, dass somit das von nicht legierten ternären Legierungen bekannte frühe Aufschmelzen besonders von Gallium verhindert wird und somit die Legierung für PVD - Beschichtungsprozesse, besonders beim Sputterprozess oder anderen PVD-Prozessen, eingesetzt werden kann. Die bekannten binären Legierungen aus Kupfer-Gallium und Kupfer-Indium im Verhältnis der π - Phase zeigen eine derartige Sprödigkeit, dass diese nicht oder nur sehr schwer mechanisch bearbeitet werden können. Auch die notwendige Thermoschockbeständigkeit ist bei den binären Legierungen nicht gegeben, so dass diese binären Legierungen nicht oder nur sehr eingeschränkt Verwendung finden.

Die Zusammensetzung der Phase wurde an einem Rasterelektronenmikroskop mit EDX - Analyse statistisch ermittelt. Als Proben dienten drei metallographische Anschliffe verschiedener chemischer Zusammensetzungen aus dem System CuInGa. In jeder Probe war die charakteristische π - Phase zu finden. In jedem Anschliff wurde die Zusammensetzung an 10 Punkten untersucht, die augenscheinlich zur π - Phase gehörten.

Die π - Phase entspricht demnach folgender Zusammensetzung:

**CuInGa: 59 - 63 : 9-22 : 19 - 28 wt%**

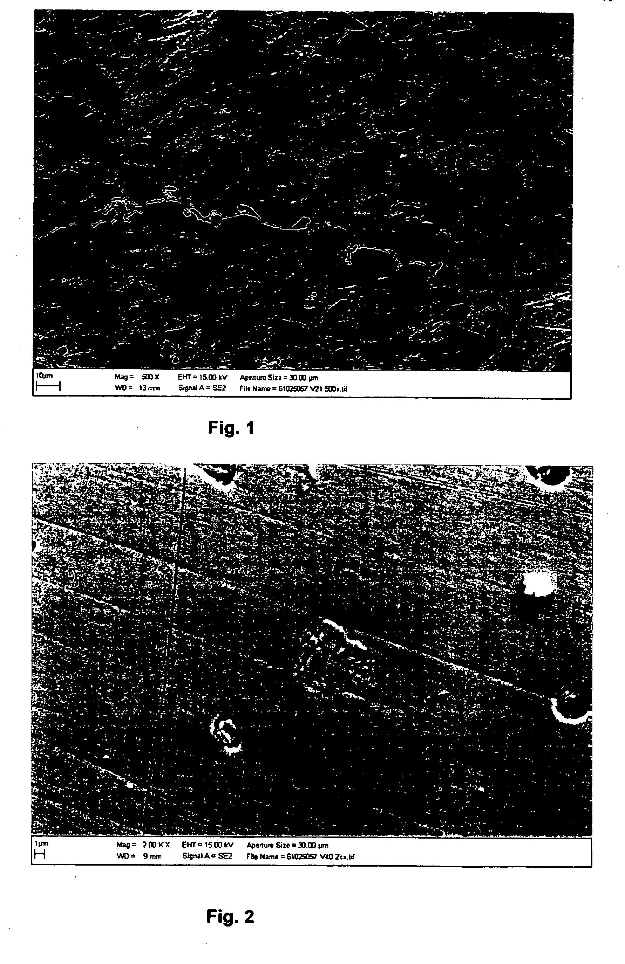

Fig. 1 zeigt die Anschliffbild der Legierung CuInGa 35,8 - 52,4 - 11,8wt%, schnell abgekühlt. Die π - Phase sind die dunklen Bereiche, die von einer Indium-Matrix umgeben sind.

Eine Röntgenphasenanalyse wurde durchgeführt.

Ausgehend von den obigen Daten wurde eine Schmelze mit einer Durchschnittszusammensetzung CuInGa 62:17:21wt% hergestellt und der Phasenbestand mittels Röntgendiffraktometrie bestimmt.

Fig. 2 zeigt ein Anschliffbild der Legierung CuInGa 62 - 17 - 21 wt%, π - Phase - mit verfahrentechnisch bedingten Gussporen.

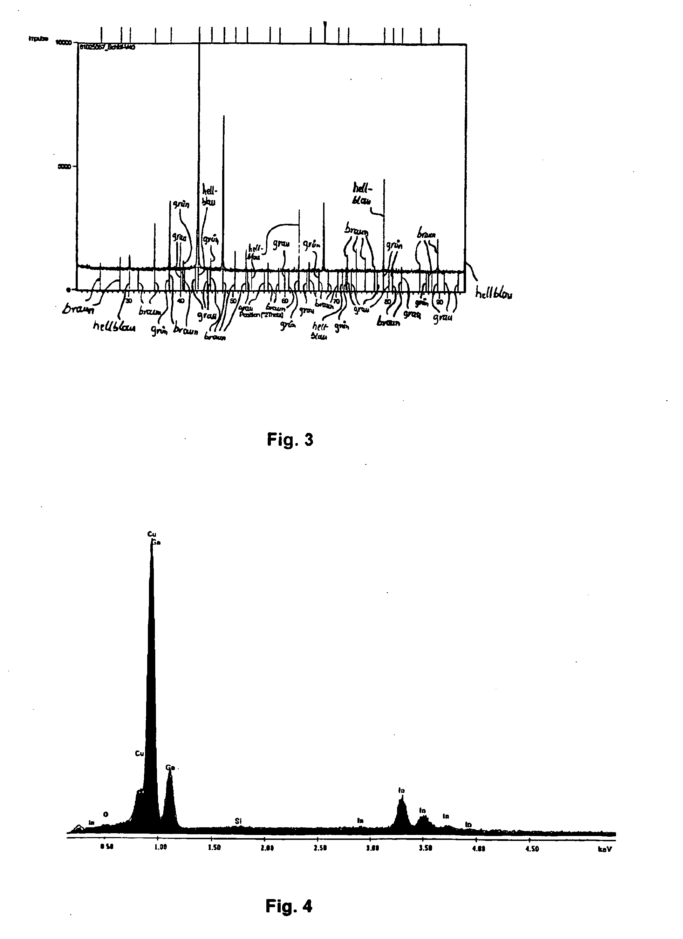

Fig 3 zeigt ein Röntgenspektrum der π - Phase.

Zwei charakteristische Peaks des Spektrums liegen bei 2 Theta - Winkeln von 37,9° und 48° und stimmen mit dem Hauptpeak der Prototyp-Phase Cu5Zn8 überein. Auch die weiteren Reflexe der Prototyp-Cu5Zn8-Phase (braune Linien ) stimmen mit dem vorliegenden Spektrum der π - Phase überein.

Neben der Prototyp-Cu5Zn8 - Phase zeigt das Spektrum noch elementares Kupfer (grau) und Gallium (grün) an sowie eine weitere Phase CuZn (hellblau), wobei die Prototyp-Phase Cu5Zn8 am stärksten mit der vorliegenden π - Phase übereinstimmt. Die Reflexe kommen durch die Gitterebenenabstände der in der Probe vorliegenden Phasen zustande.

Die elektrische Leitfähigkeit wurde bestimmt. Gemessen wurde der Durchgangswiderstand durch mehrere Achsen einer CuInGa - Scheibe mit den in Fig. 1 und 2 abgebildeten Zusammensetzungen. Der Widerstand lag dabei unterhalb des Messbereich des Multimeters, der bei ca. 300 mΩ liegt. Das Material ist damit sehr gut elektrisch leitfähig.

Die Herstellung erfolgt schmelzmetallurgisch unter Schutzgasatmosphäre bei einem Druck von 100 - 600mbar. Bei kleinerem Druck verdampft zu viel In und Ga. Die Schmelze erfolgt in einem Tiegel mit den Eigenschaften:
➢ Wärmeleitfähigkeit < 80 W/mK
➢ Elektische Leitfähigkeit > 0,05 MS/m
➢ Chemische Resistenz gegenüber der Schmelze.
➢ Temperaturschockbeständigkeit.
➢ Indirekt gekühlt

Die Abkühlgeschwindigkeit wird so eingestellt, dass die Kristallgröße 10 µm nicht übersteigt. Der Energieeintrag kann induktiv, über Lichtbogen oder Heizelemente usw. erfolgen. Als Rohstoffe dienen die Elemente Cu, In und Ga sowie jegliche binären oder ternären Vorlegierungen dieses Dreistoffsystems.

Fig. 4 zeigt ein EDX - Spektrum zur Bestimmung der chem. Zusammensetzung der in Fig. 1 zu sehenden dunklen Bereiche (π - Phase).

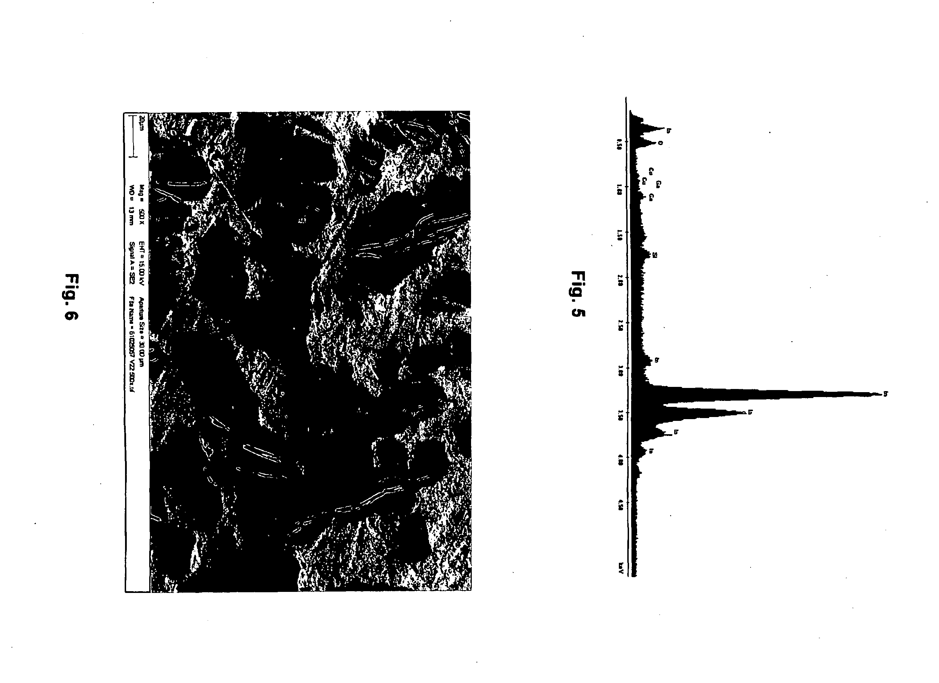

Fig. 5 zeigt ein EDX - Spektrum der hellen Matrix aus Fig.1, das fast nur Indium anzeigt. Kupfer und Gallium sind nur noch im Maßstab von Verunreinigungen enthalten.

Fig. 6 zeigt die π - Phase, die bei langsamerer Abkühlung größere Körner ausbildet und rissempfindlich wird.

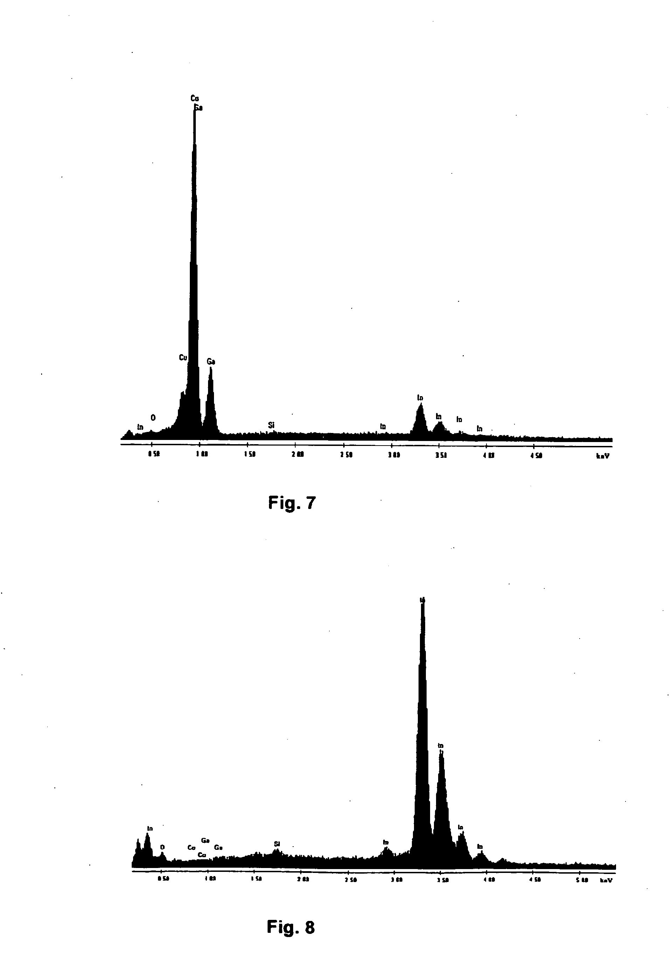

Fig. 7 zeigt die π - Phase der langsam abgekühlten Schmelze und weist ein gleiches EDX - Spektrum auf wie in Fig. 2.

Fig. 8 zeigt, dass die Matrix der langsam abgekühlten Schmelz wiederum fast ausschließlich aus Indium besteht.

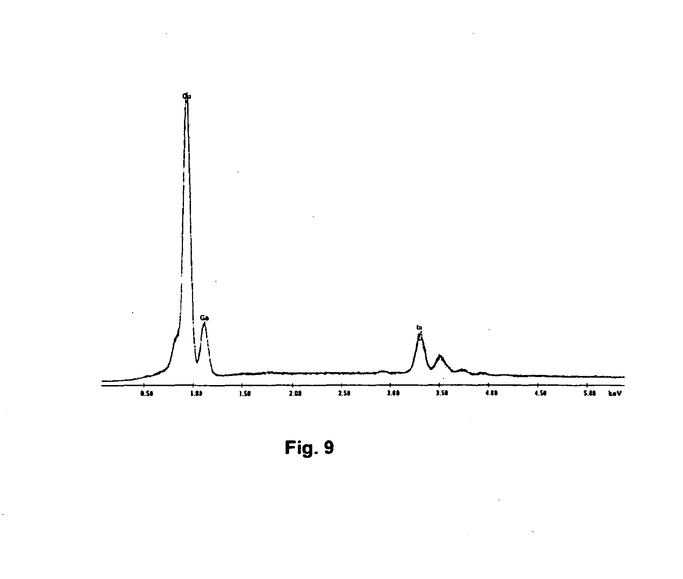

Die EDX - Spektren gemäß Fig. 9 von sechs untersuchten Punkten auf der Schlifffläche von Fig. 2 zeigen deren Zusammensetzungen. Alle Punkte haben in etwa die selbe Zusammensetzung.

## Patentansprüche

1. Beschichtungswerkstoff, insbesondere zur Herstellung von Sputtertargets, Rohrkathoden und dergleichen, aus einer Kupfer-Indium-Gallium(CuInGa-)Legierung, umfassend eine Indium-Matrix, in der eine Phase nach Art einer Prototyp-Cu5Zn8-Phase, in der die Gitterplätze der Zinkatome (Zn) durch Galliumatome besetzt sind (Gallium-substituierte Cu5Zn8-Phase), ausgebildet ist und bei welcher Gallium-substituierten Cu5Zn8-Phase zugleich Indium mit einem Anteil von bis zu 22 Gew.% in die Elementarzelle oder Phase eingelagert ist,
**dadurch gekennzeichnet, dass** die Gallium-substituierte Cu5Zn8-Phase eine Zusammensetzung mit den Anteilsbereichen Cu:In:Ga von 59-63 : 9 - 22 : 19 - 28 Gew.-% aufweist.

2. Beschichtungswerkstoff nach Anspruch 1, **gekennzeichnet durch** eine Zusammensetzung von 34 - 38 Gew.-% Cu, 50 - 54 Gew.-% In und 10 - 13 Gew.-% Ga, vorzugsweise 35,8 - 52,4 - 11,8 Gew.-%.

## Claims

1. Coating material, in particular for the production of sputter targets, tubular cathodes and the like, from a copper-indium-gallium (CuInGa) alloy, comprising an indium matrix in which a phase corresponding to a Cu5Zn8 prototype phase in which the lattice sites of the zinc atoms (Zn) are occupied by gallium atoms (gallium-substituted Cu5Zn8 phase) is formed, and in which gallium-substituted Cu5Zn8 phase indium is simultaneously introduced into the elementary cell or phase, making up a proportion of up to 22 wt% **characterized in that** the gallium-substituted Cu5Zn8 phase has a composition with Cu:In:Ga proportions of 59 - 63 : 0 - 22 : 19 - 28 wt%.

2. Coating material according to claim 1, **characterized by** a composition of 34 - 38 wt% of Cu, 50 - 54 wt% of In and 10 - 13 wt% of Ga, preferably 35.8 - 52.4 - 11.8 wt%.

## Revendications

1. Matériau de revêtement en particulier pour la fabrication de cibles de circuits, de cathodes tubulaires et analogues, à base d'un alliage de cuivre/indium/gallium (CuInGa) comprenant une matrice d'indium dans laquelle une phase de type phase prototype Cu5Zn8 où les places de réseau des atomes de zinc (Zn) sont occupées par des atomes de gallium (Phase Cu5Zn8 substituée par du gallium) est formée et où, dans la phase cu5Zn8 substituée par le gallium, de l'indium à une proportion allant jusqu'à 22 % en poids est inséré simultanément dans la cellule élémentaire ou dans la phase, **caractérisé en ce que** la phase cu5Zn8 substituée par le gallium présente une composition avec des domaines de proportions Cu : In : Ga de 59-63 : 9-22 : 19-28 % en poids.

2. Revêtement selon la revendication 1 **caractérisé par** une composition de 34-38 % en poids de Cu, 50-54 % en poids d'In et 10-13 % en poids de Ga, de préférence 35,8-52,4-11,8 % en poids.
